Europäisches Patentamt

European Patent Office

Office européen des brevets

(11) Veröffentlichungsnummer: **0 309 849**

**A1**

## (12) EUROPÄISCHE PATENTANMELDUNG

(21) Anmeldenummer: 88115331.6

(22) Anmeldetag: 19.09.88

(51) Int. Cl.⁴: **C12Q 1/68** , **G01N 33/532**

(30) Priorität: 28.09.87 DE 3732680

(43) Veröffentlichungstag der Anmeldung:
05.04.89 Patentblatt 89/14

(84) Benannte Vertragsstaaten:
AT BE CH DE ES FR GB GR IT LI NL SE

(71) Anmelder: **Siemens Aktiengesellschaft Berlin und München**
**Wittelsbacherplatz 2**
**D-8000 München 2(DE)**

(72) Erfinder: **Sarközi, Imre, Dipl.-Ing.**
**Karl-Witthalm-Strasse 42**
**D-8000 München 70(DE)**

(54) **Verfahren zur Entzerrung der Impulsbreiten eines Digitalsignals.**

(57) In digitalen Nachrichtenübertragungssystemen werden die übertragenen Digitalsignale mit Leitungsentzerrern regeneriert. Da bei digitalen Taktrückgewinnungseinrichtungen höhere Anforderungen an die Entzerrung gestellt werden ist es notwendig, die Impulsbreiten nochmals zu entzerren.

Der Beginn der Impulse des entzerrten Digitalsignals (D3) wird aus den vorderen Flanken der zu entzerrenden Impulse des Digitalsignals (D2) und das Ende der Impulse des entzerrten Digitalsignals (D3) aus den vorderen Flanken der Impulse eines Daten-Hilfstakts (DHT) abgeleitet. Dieses Verfahren läßt sich beispielsweise in einer integrierten Schaltung mit zwei D-Flipflops (22,23) durchführen, die die Impulse von einem JK-Flipflop (26) gesteuert abwechselnd verarbeitet. Dadurch lassen sich auch Digitalsignale (D2) einer Bitrate gleich oder größer 34 Mbit s verarbeiten.

Digitale Taktrückgewinnungseinrichtungen in Digitalsignal-Multiplexgeräten und Verteilermultiplexern.

FIG 6a

EP 0 309 849 A1

## Verfahren zur Entzerrung der Impulsbreiten eines Digitalsignals

Die Erfindung bezieht sich auf ein Verfahren und Anordnungen zur Entzerrung der Impulsbreiten eines spikefreien Digitalsignals mit Hilfe des zugehörigen Daten-Hilfstakts sowie zur Unterdrükkung eventuell auftretender Spikes.

Der Daten-Hilfstakt steht in integrierten Anordnungen zur Rückgewinnung des Taktes und/oder der Taktphase eines synchronen oder plesiochronen Digitalsignals, beispielsweise in Digitalsignal-Multiplexgeräten oder -Verteilermultiplexern, nach einem älteren Vorschlag (871172334) zur Verfügung. Mehrere dieser integrierten Anordnungen benötigen zusammen nur einen Quarzoszillator.

An die Toleranzen der Impulsbreiten von Digitalsignalen, die in Leitungsentzerrern entzerrt wurden, werden für digitale Taktrückgewinnungseinrichtungen höhere Anforderungen gestellt als für analoge. Es kann daher notwendig sein, die Impulsbreiten nochmals zu entzerren.

Aufgabe der Erfindung ist es, ein einfaches Verfahren für eine derartige Impulsbreitenentzerrung anzugeben.

Ausgehend von einem Verfahren zur Entzerrung der Impulsbreiten eines spikefreien Digitalsignals mit Hilfe des zugehörigen Daten-Hilfstakts wird diese Aufgabe erfindungsgemäß dadurch gelöst, daß der Beginn der Impulse des entzerrten Digitalsignals aus den vorderen Flanken der zu entzerrenden Impulse und das Ende der Impulse des entzerrten Digitalsignals aus den vorderen Flanken der Impulse des Daten-Hilfstakts abgeleitet wird.

Damit wird das spikefreie Digitalsignal für die Abtaktung seiner Impulse vorbereitet. Die Impulsbreiten werden stets automatisch der gerade aktuellen Phasenlage der vorderen Flanke der Impulse des Daten-Hilfstakts angepaßt.

Enthalten die zu entzerrenden Digitalsignale Spikes, dann ist es vorteilhaft, wenn die Impulse des spikebehafteten Digitalsignals verzögert und diese mit den unverzögerten Impulsen des spikebehafteten Digitalsignals vor der Entzerrung zu dem spikefreien Digitalsignal UND - verknüpft werden.

Eine erste vorteilhafte Anordnung zur Durchführung des Verfahrens besteht darin, daß ein erstes D-Flipflop vorgesehen ist, dessen Takteingang als Eingang für das spikefreie Digitalsignal dient, dessen Q-Ausgang als Ausgang für das entzerrte Digitalsignal dient und dessen D- Eingang mit einem Eingang für ein logisches "H" verbunden ist, und daß ein zweites D-Flipflop vorgesehen ist, dessen Takteingang als Eingang für den Daten-Hilfstakt dient und dessen $\overline{Q}$ -Ausgang mit dem Rücksetzeingang des ersten D-Flipflops, dessen Rücksetzeingang mit dem Q-Ausgang des ersten D-Flipflops und dessen D-Eingang mit dem Eingang für das logische "H" verbunden ist.

Eine zweite vorteilhafte Anordnung zur Durchführung des Verfahrens besteht darin, daß ein drittes D-Flipflop vorgesehen ist, dessen Takteingang als Eingang für das spikefreie Digitalsignal dient und dessen D- Eingang mit dem Eingang für ein logisches "H" verbunden ist, daß ein viertes D-Flipflop vorgesehen ist, dessen Takteingang als Eingang für den Daten-Hilfstakts dient und dessen D- Eingang mit dem Eingang für das logische "H" verbunden ist und daß ein erstes UND-Gatter vorgesehen ist, dessen erster Eingang mit dem Q-Ausgang des dritten D-Flipflops und dem Rücksetzeingang des vierten D-Flipflops und dessen zweiter Eingang mit dem $\overline{Q}$ -Ausgang des vierten D-Flipflops und dem Rücksetzeingang des dritten D-Flipflops verbunden sind und dessen Ausgang als Ausgang für das entzerrte Digitalsignal dient.

Eine dritte Anordnung zur Durchführung des Verfahrens besteht darin, daß ein fünftes D-Flipflop vorgesehen ist, dessen Takteingang als Eingang für das spikefreie Digitalsignal dient und dessen Q-Ausgang als Ausgang für das entzerrte Digitalsignal dient, daß ein sechstes D-Flipflop vorgesehen ist, dessen Takteingang als Eingang für den Daten-Hilfstakt dient und dessen D-Eingang mit dem Q-Ausgang des fünften D-Flipflops verbunden ist und daß ein erstes NAND-Gatter vorgesehen ist, dessen erster Eingang mit dem Q-Ausgang des fünften D-Flipflops, dessen zweiter Eingang mit dem Q-Ausgang des sechsten D-Flipflops und dessen Ausgang mit den Rücksetzeingängen des fünften und sechsten D-Flipflops verbunden sind.

Eine vorteilhafte Ausgestaltung des erfindungsgemäßen Impulsbreitenentzerrers in einer integrierten Schaltung besteht darin, daß ein siebentes D-Flipflop vorgesehen ist, dessen Takteingang als Eingang für das spikefreie Digitalsignal dient, daß ein achtes D-Flipflop vorgesehen ist, dessen Takteingang ebenfalls als Eingang für das spikefreie Digitalsignal dient, daß ein zweites NAND-Gatter vorgesehen ist, dessen erster Eingang mit dem Q-Ausgang des siebenten D-Flipflops und dessen zweiter Eingang mit dem Q-Ausgang des achten D-Flipflops verbunden sind und dessen Ausgang als Ausgang der Anordnung dient, daß ein JK-Flipflop vorgesehen ist, dessen Takteingang als Eingang für den Daten-Hilfstakt und dessen Rücksetzeingang als Eingang für ein Einstellsignal dienen und dessen J-Eingang mit dem $\overline{Q}$ -Ausgang des siebenten D-Flipflops und dessen K-Eingang mit dem $\overline{Q}$ -Ausgang des achten D-Flipflops verbunden sind, daß ein NOR-Gatter vorgesehen ist, dessen invertierender erster Eingang mit dem Eingang für das Einstellsignal, dessen zweiter Eingang mit dem Q-Ausgang des JK-Flipflops und dessen Ausgang mit dem Setzeingang des siebenten D-Flipflops verbunden sind, und daß ein Inverter vorgesehen ist, dessen Eingang mit dem $\overline{Q}$-Ausgang des JK-Flipflops und dessen Ausgang mit dem Setzeingang des achten D-Flipflops verbunden sind.

Eine Anordnung zur Beseitigung von Spikes ist derart ausgebildet, daß ein zweites UND-Gatter vorgesehen ist, dessen erster Eingang über ein Verzögerungsglied und dessen zweiter Eingang unmittelbar mit dem Eingang für das spikebehaftete Digitalsignal verbunden sind und dessen Ausgang als Ausgang für das spikefreie Digitalsignal dient.

Für eine Realisierung in einer integrierten Schaltung ist es vorteilhaft, wenn als Verzögerungsglied zwei Inverter vorgesehen sind.

Anhand von Ausführungsbeispielen wird die Erfindung nachstehend näher erläutert:

Fig. 1 zeigt einen Impulsbreitenentzerrer mit vorgeschalteter Spikeunterdrückung,

Fig. 2a zeigt eine Spikeunterdrückungseinrichtung,

Fig. 2b zeigt einen Pulsplan zur Spikeunterdrückung nach Fig. 2a,

Fig. 3 zeigt einen ersten Impulsbreitenentzerrer,

Fig. 4 zeigt einen zweiten Impulsbreitenentzerrer und

Fig. 5 zeigt einen dritten Impulsbreitenentzerrer.

Fig. 6a zeigt einen integrierten Impulsbreitenentzerrer mit Spikeunterdrückung und

Fig. 6b zeigt einen Pulsplan zum integrierten Impulsbreitenentzerrer.

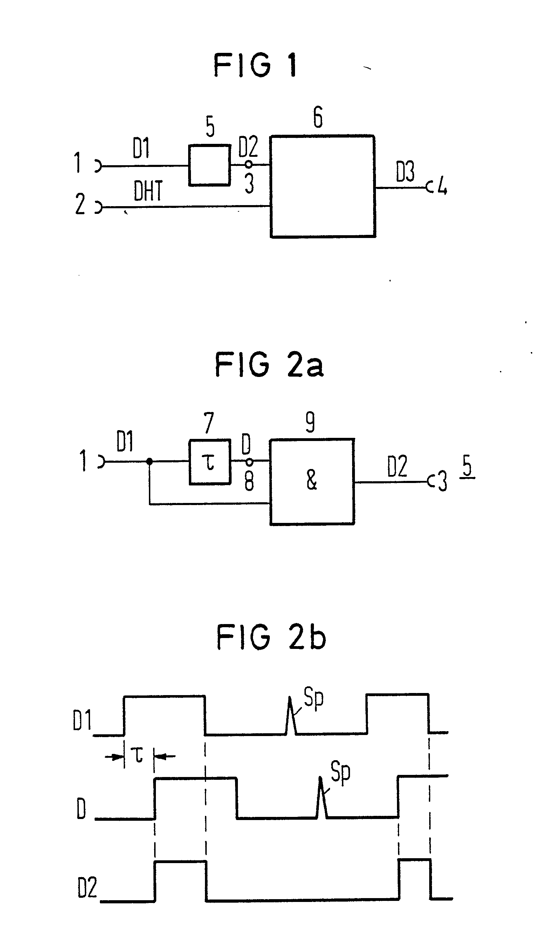

Fig. 1 zeigt einen Impulsbreitenentzerrer 6 mit vorgeschalteter Spikeunterdrückungeinrichtung 5.

Ein spikebehaftetes Digitalsignal D1 wird einem Eingang 1 zugeführt und in einer Spikeunterdrückungseinrichtung 5 von den Spikes befreit. Das spikefreie Digitalsignal D2 wird einem Impulsbreitenentzerrer 6 über einen Eingang 3 und ein Daten-Hilfstakt DHT über einen Eingang 2 zugeführt. Das entzerrte Digitalsignal D3 ist dem Ausgang 4 zu entnehmen.

Fig. 2a zeigt die Spikeunterdrückungseinrichtung 5. Diese enthält ein Verzögerungsglied 7 für eine Verzögerungszeit und ein UND-Gatter 9.

Fig. 2b zeigt die Wirkungsweise der Spikeunterdrückungseinrichtung 5 anhand eines Pulsplans. Oben ist ein spikebehaftetes Digitalsignal D1 mit einem Spike Sp gezeigt. Dieses wird im Verzögerungsglied 7 um die Zeit verzögert, was der mittlere Puls D zeigt. Das unten dargestellte Digitalsignal D2 entsteht aus einer UND-Verknüpfung der oberen Digitalsignale D1 und D.

Da die Spikes Sp in den Digitalsignalen D1 und D zeitlich nicht überlappen, entfallen sie bie der UND-Verknüpfung. Die Größe der Zeit bestimmt demnach die maximale Impulsbreite der Spikes, die unterdrückt werden können.

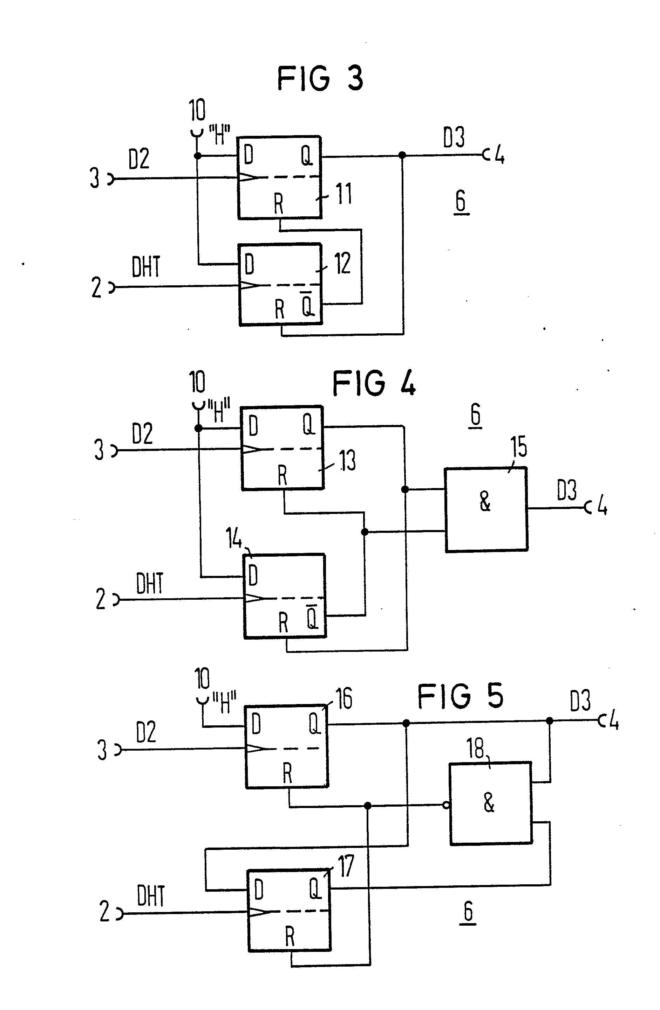

Fig. 3 zeigt die erste Variante des Impulsbreitenentzerrers 6. Sie enthält zwei D-Flipflops 11 und 12.

Liegt am Ausgang 4 ein logisches "L", dann ist das D-Flipflop 12 dauernd zurückgesetzt und sein $\overline{Q}$-Ausgang und der Rücksetzeingang haben den Zustand logisch "H". Trifft jetzt am Eingang 3 die vordere Flanke eines Impulses ein, dann geht der Zustand logisch "H" vom D-Eingang auf den Q-Ausgang des D-Flipflops 11 über, und es entsteht die vordere Flanke des entzerrten Impulses am Ausgang 4. Damit nimmt auch der Rücksetzeingang des D-Flipflops 12 den Zustand logisch "H" an. Trifft jetzt am Eingang 2 die vordere Flanke eines Impulses des Daten-Hilfstaktes DHT ein, dann nimmt der $\overline{Q}$-Ausgang des D-Flipflops 12 den Zustand logisch "L" an, was sich auf den Rücksetzeingang des D-Flipflops 11 überträgt und einen Übergang seines Q-Ausgangs auf logisch "L" bewirkt und damit die Bildung der hinteren Flanke des entzerrten Impulses auslöst. Der Rücksetzeingang des D-Flipflops 12 erhält den Zustand logisch "L" und reagiert nicht mehr auf weitere Impulse am Eingang 2.

Fig. 4 zeigt die zweite Variante des Impulsbreitenentzerrers 6 mit D-Flipflops 13 und 14 und einem UND-Gatter 15.

Die Verdrahtung der D-Flipflops 13 und 14 entspricht der der D-Flipflops 11 und 12 in Fig. 3. Ein Unterschied zwischen beiden Varianten besteht nur darin, daß in Fig. 3 das entzerrte Digitalsignal D3 nicht am Q-Ausgang des D-Flipflops 13 abgenommen wird sondern sich aus einer UND-Verknüpfung zwischen diesem Q-Ausgang und dem $\overline{Q}$-Ausgang des D-Flipflops 14 ergibt. Damit wird erreicht, daß bei der Bildung der Rückflanke der entzerrten Impulse die Laufzeit im D-Flipflop 13 entfällt.

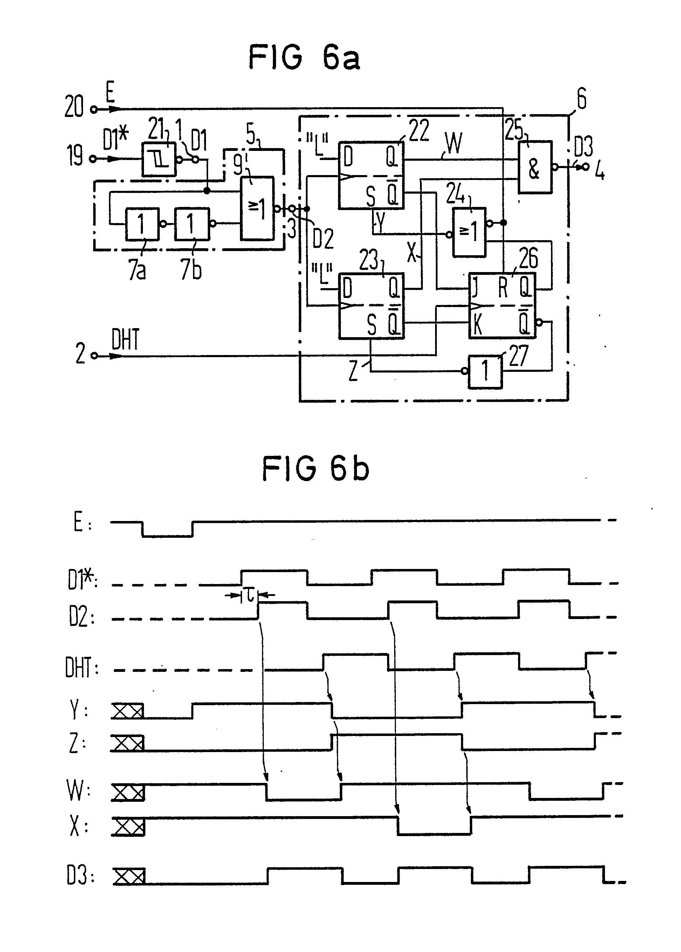

Fig. 5 zeigt die dritte Variante des Impulsbreitenentzerrers 6 mit D-Flipflops 16 une 17 und einem NAND-Gatter 18.

Liegt am Ausgang 4 ein logisches "H", dann gilt dies auch für den D-Eingang des D-Flipflops 17. Bis die nächste Vorderflanke des Daten-Hilfstakts DHT am Eingang 2 erscheint, hat der Q-Ausgang des D-Flipflops 17 einen Zustand logisch "L". Dies führt zu einem Zustand logisch "H" am Ausgang des NAND-Gatters 18 und an den Rücksetzeingängen beider D-Flipflops 16 und 17. Erscheint jetzt die Vorderflanke eines Impulses am Eingang 2, dann nimmt der Q-Ausgang des D-Flipflops 17 den logischen Zustand "H" an, was den Zustand logisch "L" an den Rücksetzeingängen beider D-Flipflops 16 und 17 bedingt. Die Q-Ausgänge des D-Flipflops 16 und 17 gehen auf logisch "L" über und es entsteht die Rückflanke des entzerrten Impulses. Damit wird erreicht, daß die interne Laufzeit im D-Flipflop 17 zwischen den Q- und $\overline{Q}$ -Ausgängen bei der Bildung der Rückflanke der entzerrten Impulse entfällt.

Fig. 6a zeigt eine integrierte Schaltung in CMOS-Technologie für hohe Bitraten wie 34 Mbit/s mit einer Spikeunterdrückungseinrichtung 5 und einem Impulsbreitenentzerrer 6 und Fig. 6b zeigt einen Pulsplan dazu.

Die Spikeunterdrückungseinrichtung 5 enthält zwei Inverter 7a und 7b als Verzögerungsglied und ein NOR-Gatter 9'. Dem Eingang 1 der Spikeunterdrückungseinrichtung 5 ist ein TTL/CMOS-Wandler 21 mit einem Eingang 19 vorgeschaltet.

Der Impulsbreitenentzerrer 6 enthält D-Flipflops 22 und 23, ein NOR-Gatter 24 mit einem invertierenden Eingang, ein NAND-Gatter 25, ein JK-Flipflop 26 und einen Inverter 27.

Ein am Eingang 19 anliegendes spikebehaftetes Digitalsignal D1* wird über ein TTL-CMOS-Wandler 21 mit entsprechender Treiberfähigkeit dem Eingang 1 der Spikeunterdrückungseinrichtung 5 zugeführt. In dieser werden die Spikes unterdrückt, wie es anhand der Fig. 2a beschrieben ist. Dabei realisieren die Inverter 7a und 7b zusammen die Verzögerungszeit $\tau$. Das spikefreie Digitalsignal D2 wird dem Eingang 3 des Impulsbreitenentzerrers 6 zugeführt und seine Impulse werden dort von den D-Flipflops 22 und 23 abwechselnd verarbeitet. Die Umschaltung zwischen den beiden D-Flipflops 22 und 23 wird von dem JK-Flipflop 26 synchron mit dem Daten-Hilfstakt DHT am Eingang 2 gesteuert. Das Aufspalten der Datenwege ist notwendig, weil in der CMOS-Technologie die Laufzeiten zu groß sein können. Dies ist durch mehrere Faktoren, wie Technologie, Temperatur und Versorgungsspannung bedingt.

Ein Einstellsignal E am Eingang bringt im Zustand logisch "L" die D-Flipflops 22 und 23 und das JK-Flipflop 26 in den Ausgangszustand. Bei letzterem bedeutet dies, daß der logische Zustand "L" an seinem Rücksetzeingang seinen Q-Ausgang in den Zustand logisch "L" versetzt. Dadurch erhält der Setzeingang des D-Flipflops 22 über das NOR-Gatter 24 einen Zustand logisch "L" (Y-Puls) und der Setzeingang des D-Flipflops 23 vom $\overline{Q}$ -Ausgang des JK-Flipflops 26 ebenfalls einen Zustand logisch "L" (Z-Puls). Damit werden die D-Flipflops 22 und 23 gesetzt, und deren Q-Ausgänge erhalten den Zustand logisch "H" (W- und Z-Puls). Der Zustand am Ausgang 4 des NAND-Gatters 25 wird dadurch logisch "L".

Geht das Einstellsignal in den Zustand logisch "H" über, erhält der Setzeingang des D-Flipflops 22 den Zustand logisch "H" (Y-Puls) und gibt das D-Flipflop 22 frei über seinen Takteingang synchron aktiviert werden zu können, während das D-Flipflop 23 durch den Zustand logisch "L" (Z-Puls) am Setzeingang weiterhin festgehalten wird.

Solange das Digitalsignal D2 am Eingang 3 keinen Impuls liefert, wird der Zustand am Ausgang 4 durch den Daten-Hilfstakt DHT nicht geändert, weil der J-und der K-Eingang des JK-Flipflops 26 im Zustand logisch "L" verharrt. Kommt jedoch ein Impuls, dann wird über den Takteingang der logische Zustand "L" vom D-Eingang auf den Q-Ausgang (W-Puls) übertragen und der J-Eingang des JK-Flipflops 26 erhält den Zustand logisch "H". Über das NAND-Gatter 25 entsteht die Vorderflanke des entzerrten Impulses am Ausgang 4.

Mit der Vorderflanke eines Impulses des Daten-Hilfstakts DHT wird am J-Eingang des JK-Flipflops 26 über dessen Takteingang ein Zustand logisch "H" eingeschrieben, worauf der Q-Ausgang dieses JK-Flipflop 26 auf logisch "H" und der Zustand am Setzeingang des D-Flipflops 22 (Y-Puls) über das NOR-Gatter 24 auf logisch "L" geht. Dadurch wird das D-Flipflop 22 zurückgesetzt und der Zustand an dessen Q-Ausgang (W-Puls) geht auf logisch "H" zurück und über das NAND-Gatter 25 entsteht am Ausgang 4 die hintere Flanke des entzerrten Impulses. Gleichzeitig erhält der Setzeingang des D-Flipflops 23 über den Inverter 27 einen Zustand logisch "H" und gibt das D-Flipflop 23 für den nächsten Impuls des Digitalsignals D2 frei, während das D-Flipflop 22 für diese Zeit festgehalten wird.

Der nächste Impuls wird somit über das D-Flipflop 23, seinen Q-Ausgang (X-Puls) und das NAND-Gatter 25 entzerrt, wobei die Umschaltung über den K-Eingang des JK-Flipflops 26 zustande kommt. Bei den nächsten Impulsen des Digitalsignals D2 wiederholt sich dieser Vorgang.

Die Pfeile in Fig. 6b zeigen, welche Zustandsänderungen in einem Puls nach einer gewissen Laufzeit Zustandsänderungen in einem anderen Puls auslösen.

## Ansprüche

1. Verfahren zur Entzerrung der Impulsbreiten eines spikefreien Digitalsignals (D2) mit Hilfe eines zugehörigen Daten-Hilfstakts (DHT),

**dadurch gekennzeichnet,**

daß der Beginn der Impulse des entzerrten Digitalsignals (D3) aus den vorderen Flanken der zu entzerrenden Impulse des spikefreien Digitalsignals (D2) und

das Ende der Impulse des entzerrten Digitalsignals (D3) aus den vorderen Flanken der Impulse des Daten-Hilfstakts (DHT) abgeleitet wird.

2. Verfahren nach Anspruch 1,
**dadurch gekennzeichnet,**
daß die Impulse eines spikebehafteten Digitalsignals (D1) verzögert und diese mit dessen unverzögerten Impulsen vor der Entzerrung zu dem spikefreien Digitalsignal (D2) UND-verknüpft werden.

3. Anordnung zur Durchführung des Verfahrens nach Anspruch 1,
**dadurch gekennzeichnet,**
daß ein erstes D-Flipflop (11) vorgesehen ist, dessen Takteingang als Eingang (3) für das spikefreie Digitalsignal (D2) dient, dessen Q-Ausgang als Ausgang (4) für das entzerrte Digitalsignal (D3) dient und dessen D-Eingang mit einem Eingang für ein logisches "H" verbunden sind, und daß ein zweites D-Flipflop (12) vorgesehen ist, dessen Takteingang als Eingang (2) für den Daten-Hilfstakt (DHT) dient und dessen Q̄-Ausgang mit dem Rücksetzeingang des ersten D-Flipflops (11), dessen Rücksetzeingang mit dem Q-Ausgang des ersten D-Flipflops (11) und dessen D-Eingang mit dem Eingang (10) für das logische "H" verbunden sind (Fig. 3).

4. Anordnung zur Durchführung des Verfahrens nach Anspruch 1,
**dadurch gekennzeichnet,**
daß ein drittes D-Flipflop (13) vorgesehen ist, dessen Takteingang als Eingang (3) für das spikefreie Digitalsignal (D2) dient und dessen D-Eingang mit dem Eingang (10) für ein logisches "H" verbunden ist,
daß ein viertes D-Flipflop (14) vorgesehen ist, dessen Takteingang als Eingang (2) für den Daten-Hilfstakt (DHT) dient und dessen D- Eingang mit einem Eingang (10) für das logische "H" verbunden sind, und
daß ein erstes UND-Gatter (15) vorgesehen ist, dessen erster Eingang mit dem Q-Ausgang des dritten D-Flipflops (13) und dem Rücksetzeingang des vierten D-Flipflops (14) und dessen zweiter Eingang mit dem Q̄-Ausgang des vierten D-Flipflops (14) und dem Rücksetzeingang des dritten D-Flipflops (13) verbunden sind und dessen Ausgang als Ausgang (4) für das entzerrte Digitalsignal (3) dient (Fig. 4).

5. Anordnung zur Durchführung des Verfahrens nach Anspruch 1,
**dadurch gekennzeichnet,**
daß ein fünftes D-Flipflop (16) vorgesehen ist, dessen Takteingang als Eingang (3) für das spikefreie Digitalsignal (D2) dient und dessen Q-Ausgang als Ausgang (4) für das entzerrte Digitalsignal (D3) dienen,
daß ein sechstes D-Flipflop (17) vorgesehen ist, dessen Takteingang als Eingang (2) für den Daten-Hilfstakt (DHT) dient und dessen D-Eingang mit dem Q-Ausgang des fünften D-Flipflops (16) verbunden ist, und

daß ein erstes NAND-Gatter (18) vorgesehen ist, dessen erster Eingang mit dem Q-Ausgang des fünften D-Flipflops (16), dessen zweiter Eingang mit dem Q-Ausgang des sechsten D-Flipflops (17) und dessen Ausgang mit den Rücksetzeingängen des fünften und sechsten D-Flipflops (16,17) verbunden sind (Fig. 5).

6. Anordnung zur Durchführung des Verfahrens nach Anspruch 1,
**dadurch gekennzeichnet,**
daß ein siebentes D-Flipflop (22) vorgesehen ist, dessen Takteingang als Eingang (3) für das spikefreie Digitalsignal (D2) dient,
daß ein achtes D-Flipflop (23) vorgesehen ist, dessen Takteingang ebenfalls als Eingang (3) für das spikefreie Digitalsignal (D2) dient,
daß ein zweites NAND-Gatter (25) vorgesehen ist, dessen erster Eingang mit dem Q-Ausgang des siebenten D-Flipflops (22) und dessen zweiter Eingang mit dem Q-Ausgang des achten D-Flipflops (23) verbunden sind und dessen Ausgang als Ausgang (4) der Anordnung dient,
daß ein JK-Flipflop (26) vorgesehen ist, dessen Takteingang als Eingang (2) für den Daten-Hilfstakt (DHT) und dessen Rücksetzeingang als Eingang (20) für ein Einstellsignal (E) dienen und dessen J-Eingang mit dem Q̄-Ausgang des siebenten D-Flipflops (22) und dessen K-Eingang mit dem Q̄-Ausgang des achten D-Flipflops (23) verbunden sind,
daß ein NOR-Gatter (24) vorgesehen ist, dessen invertierender erster Eingang mit dem Eingang (20) für das Einstellsignal (E), dessen zweiter Eingang mit dem Q-Ausgang des JK-Flipflops (26) und dessen Ausgang mit dem Setzeingang des siebenten D-Flipflops (22) verbunden sind, und
daß ein Inverter (27) vorgesehen ist, dessen Eingang mit dem Q̄-Ausgang des JK-Flipflops (26) und dessen Ausgang mit dem Setzeingang des achten D-Flipflops (23) verbunden sind (Fig. 6a).

7. Anordnung zur Durchführung des Verfahrens nach Anspruch 2,
**dadurch gekennzeichnet,**
daß ein zweites UND-Gatter (9) vorgesehen ist, dessen erster Eingang über ein Verzögerungsglied (7) und dessen zweiter Eingang unmittelbar mit dem Eingang (1) für das spikebehaftete Digitalsignalsignal (D1) verbunden sind und dessen Ausgang als Ausgang (3) für das spikefreie Digitalsignal (D2) dient (Fig. 2a).

8. Anordnung nach Anspruch 7,
**dadurch gekennzeichnet,**
daß als Verzögerungsglied (7) zwei Inverter (7a,7b) vorgesehen sind (Fig. 6a).

9. Anordnung nach einem der Ansprüche 3 bis 8,

**gekennzeichnet**

durch ihre Realisierung als integrierte Schaltung in CMOS- Technologie.

10. Anordnung nach einem der Ansprüche 3 bis 9,

**gekennzeichnet**

durch die Entzerrung von Digitalsignalen (D2) einer Bitrate gleich oder größer 34 Mbit/s.

# FIG 1

D1  5  D2  6

1 ⟩  D1  ⌷5  D2∘  ⌷6  D3  ⟨ 4

2 ⟩  DHT  3

# FIG 2a

D1  7  D  9

1 ⟩  D1  ⌷τ⌷  D∘  ⌷&⌷  D2  ⟨ 3  5

8

# FIG 2b

D1 ⎯⎯⎯⎯ Sp

|← τ →|

D ⎯⎯⎯⎯ Sp

D2

## FIG 3

## FIG 4

## FIG 5

EP 0 309 849 A1

FIG 6a

FIG 6b

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-2 037 161 (NORTH AMERICAN ROCKWELL CORP.) * Figuren 1,3; Seite 3, Zeile 24 - Seite 6, Zeile 14; Seite 7, Zeile 26 - Seite 10, Zeile 9 * | 1 | H 03 K 5/01 |
| Y | | 2,7 | |
| A | --- | 9 | |
| Y | US-A-4 233 525 (TAKAHASHI) * Zusammenfassung; Figuren 1,2,4,5; Spalte 2, Zeile 60 - Spalte 3, Zeile 47; Spalte 4, Zeilen 1-52 * --- | 2,7 | |
| A | DE-A-3 239 936 (PHILIPS) * Zusammenfassung; Figur 1; Seite 4, Zeilen 10-29 * --- | 3-6 | |
| A | US-A-4 554 445 (CHASSE et al.) * Zusammenfassung; Figuren 1,2; Spalte 2, Zeile 49 - Spalte 4, Zeile 6 * --- | 1,3-6 | |
| A | PATENT ABSTRACTS OF JAPAN, Band 5, Nr. 86 (E-60)[758], 5. Juni 1981; & JP-A-56 32 824 (MITSUBISHI DENKI K.K.) 02-04-1981 * Zusammenfassung * ----- | | RECHERCHIERTE SACHGEBIETE (Int. Cl.4) H 03 K G 11 B |

Der vorliegende Recherchenbericht wurde für alle Patentansprüche erstellt

| Recherchenort | Abschlußdatum der Recherche | Prüfer |
|---|---|---|
| DEN HAAG | 15-12-1988 | HARTBERGER, J. |